# EUROPÄISCHE PATENTSCHRIFT

(11) **EP 1 567 878 B1**
(45) Veröffentlichungstag und Bekanntmachung des Hinweises auf die Patenterteilung: **27.02.2008**
(21) Anmeldenummer: 03769233.2
(22) Anmeldetag: 09.10.2003
(51) Int. Cl.: G01R 33/09

(54) **MAGNETORESISTIVES SENSORELEMENT UND VERFAHREN ZUR REDUKTION DES WINKELFEHLERS EINES MAGNETORESISTIVEN SENSORELEMENTS**
MAGNETORESISTIVE SENSOR ELEMENT AND METHOD FOR REDUCING THE ANGULAR ERROR OF A MAGNETORESISTIVE SENSOR ELEMENT
ELEMENT DE DETECTION MAGNETORESISTIF ET PROCEDE POUR DIMINUER LE DEFAUT D'ALIGNEMENT ANGULAIRE D'UN ELEMENT DE DETECTION MAGNETORESISTIF

(30) Priorität: 27.11.2002 DE 10255327
(43) Veröffentlichungstag der Anmeldung: 31.08.2005
(73) Patentinhaber: ROBERT BOSCH GMBH, 70442 Stuttgart (DE)
(72) Erfinder: MAY, Ulrich, 52064 Aachen (DE); FARBER, Paul, 70197 Stuttgart (DE); KITTEL, Hartmut, 71287 Weissach-Flacht (DE); SIEGLE, Henrik, 71229 Leonberg (DE); HERRMANN, Ingo, 70771 Leinfelden-Echterdingen (DE); SCHMOLLNGRUBER, Peter, 71134 Aidlingen (DE)
(86) Internationale Anmeldenummer: PCT/DE2003/003339
(87) Internationale Veröffentlichungsnummer: WO 2004/048986

(56) Entgegenhaltungen:
- WO-A-03/107025
- DE-C- 19 742 366
- KIM K Y ET AL: "EFFECT OF THE SHAPE ANISOTROPY ON THE GIANT MAGNETORESISTANCE PROPERTIES" IEEE TRANSACTIONS ON MAGNETICS, IEEE INC. NEW YORK, US, Bd. 37, Nr. 5, PART 1, September 2001 (2001-09), Seiten 3332-3335, XP001083103 ISSN: 0018-9464

## Beschreibung

Die Erfindung betrifft ein magnetoresistives Sensorelement sowie ein Verfahren zur Reduktion des Winkelfehlers eines magnetoresistiven Sensorelementes nach der Gattung der unabhängigen Ansprüche.

### Stand der Technik

Wegen ihres gegenüber AMR-Winkelsensoren vergrößerten Messbereiches von 360° und vergrößerten Signalamplituden und damit geringerer Störanfälligkeit werden zunehmend magnetoresistive Sensorelemente auf der Grundlage des GMR-Effektes ("Giant Magneto Resistance") nach dem sogenannten Spin-Valve-Prinzip zur Winkelerfassung in Kraftfahrzeugen herangezogen. Das Sensorsystem weist dazu einen felderzeugenden Magneten und einen in dessen Nähe positionierten Winkelsensor bzw. allgemeiner ein magnetoresistives Sensorelement auf, wobei die Richtung des auf dieses Sensorelement einwirkenden Magnetfeldes erfasst wird.

Der Aufbau von magnetoresistiven Sensorelementen auf der Grundlage des Spin-Valve-Prinzips unterscheidet sich von GMR-Sensorelementen oder GMR-Multilagen, die eine abwechselnde Folge von ferromagnetischen und nichtmagnetischen Dünnschichten aufweisen, dahingehend, dass in der Regel lediglich zwei ferromagnetische Dünnschichten vorgesehen sind, die durch eine nichtmagnetische Zwischenschicht getrennt werden. Die Richtung der Magnetisierung einer dieser beiden ferromagnetischen Schichten wird dann durch eine Ankoppelung dieser Schicht an eine antiferromagnetische Schicht festgehalten (gepinnt). Die andere Schicht, die sogenannte freie Schicht oder Detektionsschicht, kann in einem äußeren Magnetfeld die Richtung ihrer Magnetisierung dagegen frei rotieren, so dass sich ein über die Richtung des äußeren Magnetfeldes veränderbarer Winkel zwischen der Richtung der Magnetisierung in der Detektionsschicht und der Richtung der Magnetisierung in der gepinnten Schicht, d.h. der sogenannten Referenzschicht, einstellt. Der elektrische Widerstand des Sensorelementes ist weiter eine Funktion dieses Winkels, so dass durch Messung des elektrischen Widerstandes dieser Winkel bestimmt werden kann.

Zum Festhalten der Richtung der Magnetisierung der Referenzschicht ist alternativ auch ein Schichtsystem mit einer antiferromagnetischen Schicht, einer darauf befindlichen ferromagnetischen Schicht, einer darauf befindlichen nicht magnetischen Schicht und einer darauf befindlichen ferromagnetischen Schicht geeignet, wobei die nicht magnetische Schicht zwischen den beiden ferromagnetischen Schichten eine antiferromagnetische Kopplung zwischen diesen vermittelt. Ein solches Schichtsystem wird als künstlicher Antiferromagnet bezeichnet.

Um einen Winkelsensor mit auf der Grundlage des GMR-Effektes arbeitenden und nach dem Spin-Valve-Prinzip aufgebauten magnetoresistiven Schichtsystemen ausführen zu können, ist es günstig, eine Mehrzahl derartiger magnetoresistiver Schichtsysteme in zwei Wheatstone'schen Brückenschaltungen miteinander zu verschalten, wobei eine Brücke gegenüber der anderen hinsichtlich der Richtung der Magnetisierung in der Referenzschicht beispielsweise um 90° gedreht ist. In einem beispielsweise rotierenden äußeren Magnetfeld führt dies zu einer Phasenverschiebung der Ausgangssignale beider Brücken. Man spricht hier von einer "Cosinus"-Brücke und einer "Sinus"-Brücke gemäß der Abhängigkeit des Ausgangssignals der beiden Brücken von der äußeren Magnetfeldrichtung. Jede der einzelnen Wheatstone'schen Brücken besteht weiter aus magnetoresistiven Schichtsystemen in Form von vier Einzelwiderständen, die paarweise eine Richtung der Magnetisierung in der Referenzschicht von beispielsweise 180° zueinander aufweisen.

Aus der DE 19742366 C1 ist eine Einrichtung mit magnetoresistivem Sensorelement und zugeordneter Magnetisierungsvorrichtung bekannt. Die Vorrichtung weist stromführende, magnetische Einstellfelder erzeugende Leiterbahnen auf, die sich untereinander kreuzen. Mit einer der Leiterbahnen wird dabei ein oszillierendes, abklingendes Zusatzfeld hervorgerufen. Dadurch wird in den so genannten Bias-Schichten ein Zustand minimaler Energie erreicht. Weiterhin ist ein Mehrschichtensystem mit einem künstlichen AntiFerromagneten vorgeschlagen, der drei ferromagnetische Bias-Schichten aufweist, zwischen denen jeweils eine nicht magnetische Koppelschicht angeordnet ist.

Einen Überblick über den Aufbau von magnetoresistiven Schichtsystemen, die nach dem Spin-Valve-Prinzip aufgebaut sind und nach dem GMR-Effekt arbeiten, wird in WO 00/79298 A2 gegeben. Dort ist auch die Verschaltung derartiger magnetoresistiver Schichtsysteme in Form von zwei zueinander um 90° gedrehten Wheatstone'schen Brückenschaltungen sowie der Aufbau eines magnetoresistiven Schichtsystems mit einem künstlichen Antiferromagneten zur Einstellung einer festen Richtung der Magnetisierung der Referenzschicht des Schichtsystems erläutert.

Bei magnetoresistiven Schichtsystemen, die auf der Grundlage des GMR-Effeketes arbeiten und nach dem Spin-Valve-Prinzip aufgebaut sind, treten durch zwei intrinsische Effekte Messfehler auf.

So weist die Detektionsschicht oder freie Schicht einerseits eine gewisse Anisotropie und andererseits eine Restkopplung mit der Referenzschicht bzw gepinnten Schicht auf, d.h. sie folgt dem äußeren Magnetfeld hinsichtlich dessen Richtung nicht optimal. Daneben beobachtet man auch, dass die Richtung der Magnetisierung der Referenzschicht nicht völlig unverändert bleibt, wenn ein äußeres Magnetfeld auf diese einwirkt. Insofern tritt häufig auch eine geringe Änderung der Richtung der Magnetisierung der Referenzschicht bei Einwirken eines äußeren Magnetfeldes auf, was das Messergebnis verfälscht.

Aufgabe der vorliegenden Erfindung war die Bereitstellung eines magnetoresistiven Sensorelementes mit einem gegenüber dem Stand der Technik reduzierten Winkelfehler und eines Verfahrens zur Reduktion des. Winkelfehlers eines magnetoresistiven Sensorelementes, um so dieses magnetoresistive Sensorelement als besonders präzisen Winkelsensor, insbesondere in Kraftfarzeugen, einsetzen zu können.

### Vorteile der Erfindung

Das erfindungsgemäße magnetoresistive Sensorelement gemäß Anspruch 1 und das erfindungsgemäße Verfahren zur Reduktion des Winkelfehlers eines magnetoresistiven Sensorelementes gemäß Anspruch 11 hat gegenüber dem Stand der Technik den Vorteil, dass der Winkelfehler des Schichtsystems als Funktion des Winkels zwischen der Magnetisierungsrichtung der Referenzschicht in Abwesenheit eines äußeren Magnetfeldes und der Längsrichtung des streifenförmigen Schichtsystems sowie der Feldstärke des von außen einwirkenden Magnetfeldes zumindest näherungsweise minimal ist. Insbesondere lassen sich Winkelfehler von weniger als 0,5°, insbesondere weniger als 0,2°, erreichen.

Vorteilhafte Weiterbildungen der Erfindung ergeben sich aus den in den Unteransprüchen genannten Maßnahmen.

So ist besonders vorteilhaft, wenn man neben der geeigneten Auswahl des Winkels zwischen der Magnetisierungsrichtung in der Referenzschicht in Abwesenheit des äußeren Feldes und der Längsrichtung des streifenförmigen Schichtsystemes sowie der Feldstärke des äußeren Magnetfeldes zur weiteren Minimierung des Winkelfehlers auch noch die Breite des streifenförmigen Schichtsystemes verändert, und so den genannten Winkel und die Breite des streifenförmigen Schichtsystemes jeweils auf das bei Betrieb des Sensorelementes auf dieses einwirkende Magnetfeld, dessen Stärke aus einem vorgegebenen Arbeitsintervall ausgewählt ist, aufeinander abstimmt. Der Winkelfehler wird somit als Funktion dieser Größen minimiert.

Dieses Vorgehen beruht auf der Erkenntnis, dass durch geschickte Ausnutzung von mikroskopischen Energietermen die bei magnetoresistiven Sensorelementen nach dem Spin-Valve-Prinzip auftretenden intrinsischen Effekte, die zu Messfehlern führen, minimiert werden können.

So ist ein wesentlicher derartiger Effekt bzw. Energiebeitrag die Formanisotropie, die bei einer Strukturierung des magnetoresistiven Schichtsystems in Streifen auftritt. Daher lässt sich der Winkelfehler des magnetoresistiven Schichtsystems durch geschickte Ausnutzung der Formanisotropie beispielsweise einer mäanderförmigen Leiterbahn, die aus einzelnen streifenförmigen Abschnitten besteht, in Kombination mit einer geeigneten Wahl der Pinning-Richtung der Referenzschicht des Schichtsystems in diesem streifenförmigen Bereich sowie unter Berücksichtung der auf das Sensorelement bei dessen Betrieb einwirkenden äußeren Magnetfeldstärken minimieren.

Ein besonders geringer Winkelfehler ergibt sich daher bei einer geeigneten Kombination des Layouts des magnetoresistiven Schichtsystems in Draufsicht, vor allem hinsichtlich der Breite der einzelnen streifenförmigen Schichtsystemabschnitte, und der Richtung der Magnetisierung der Referenzschicht, d.h. der sogenannten Pinningrichtung, in diesen einzelnen streifenförmigen Abschnitten, sowie unter gleichzeitiger Berücksichtigung des Betrages des auf das magnetoresistive Sensorelement bei Betrieb einwirkenden äußeren Magnetfeldes.

Insbesondere ist vorteilhaft, dass durch eine Strukturierung des magnetoresistiven Schichtsystems in streifenförmige Abschnitte mit einer bevorzugten Breite im Bereich von 1 µm bis 20 µm der Energiebeitrag der Formanisotropie bei bestimmten Winkeln zwischen der Längsrichtung des Streifens und der Pinningrichtung bzw. der Richtung der Magnetisierung der Referenzschicht in Abwesenheit eines äußeren Magnetfeldes oder bei einem vernachlässigbar schwachen äußeren Magnetfeld einen positiven Einfluss auf den Winkelfehler hat.

So hat sich als besonders vorteilhaft herausgestellt, wenn dieser Winkel zwischen der Magnetisierungsrichtung in Abwesenheit des äußeren Magnetfeldes und der Längsrichtung des streifenförmigen Schichtsystems zumindest näherungsweise 0°, 90°, 180° oder 270° beträgt, wobei weiter vorteilhaft die Feldstärke des äußeren Magnetfeldes aus einem Arbeitsintervall von 0,8 kA/m bis 80 kA/m, insbesondere 8 kA/m bis 30 kA/m, ausgewählt ist.

In diesem Zusammenhang ist weiter vorteilhaft, wenn das Layout des magnetoresistiven Sensorelementes derart gewählt ist, dass möglichst alle streifenförmigen Abschnitte des Schichtsystems in Draufsicht nur eine gemeinsame Richtung zwischen der Längsrichtung des streifenförmigen Schichtsystems in diesem Bereich und der Pinningrichtung aufweisen.

Dazu ist es vorteilhaft, wenn die diese Bedingung nicht erfüllenden Abschnitte des magnetoresistiven Sensorelementes durch eine elektrisch gut leitfähige Leitschicht, insbesondere eine Beschichtung aus Aluminium, überbrückt bzw. elektrisch kurzgeschlossen werden, oder wenn diese Abschnitte des magnetoresistiven Sensorelements aus entsprechenden, elektrisch gut leitenden Abschnitten ausgeführt sind.

Weiter ist vorteilhaft, wenn das streifenförmige Schichtsystem in Draufsicht in Form eines Mäanders mit bereichsweise parallel verlaufenden Streifenabschnitten ausgebildet ist, wobei die Magnetisierungsrichtungen der Referenzschicht der parallelen Streifenabschnitte zumindest näherungsweise parallel zueinander orientiert sind, und wobei nicht parallel sondern insbesondere senkrecht zu diesen Streifenabschnitten verlaufende Streifenabschnitte mit dieser Leitschicht versehen sind.

Besonders vorteilhaft ist weiter, wenn das streifenförmige magnetoresistive Schichtsystem zur Stabilisierung der Richtung der Magnetisierung der Referenzschicht einen künstlichen Antiferromagneten aufweist. Dies führt zu einer besonders guten und stabilen Vorgabe der Magnetisierungsrichtung der Referenzschicht.

### Zeichnungen

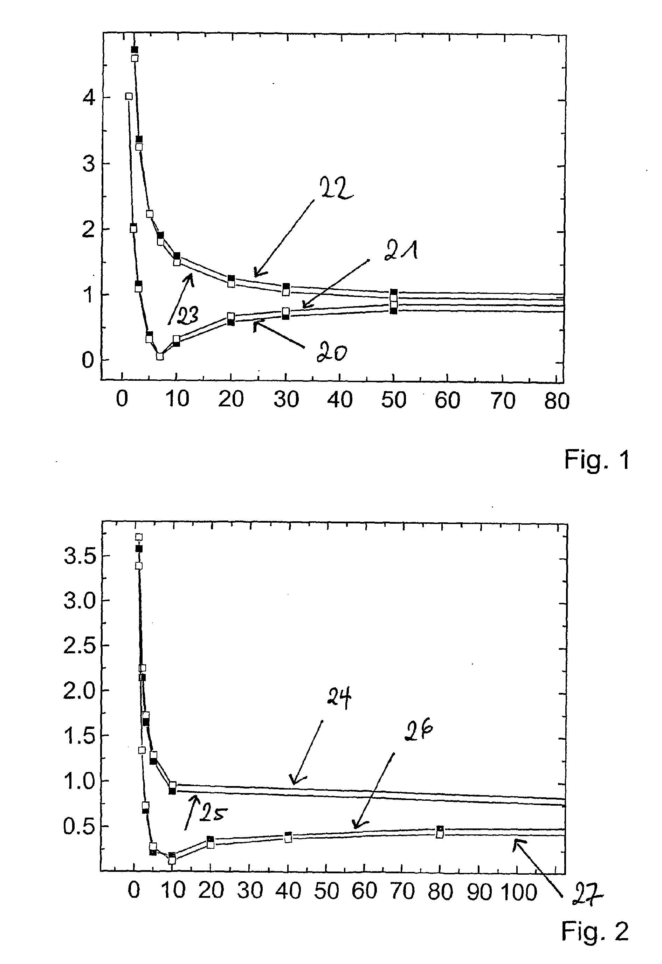

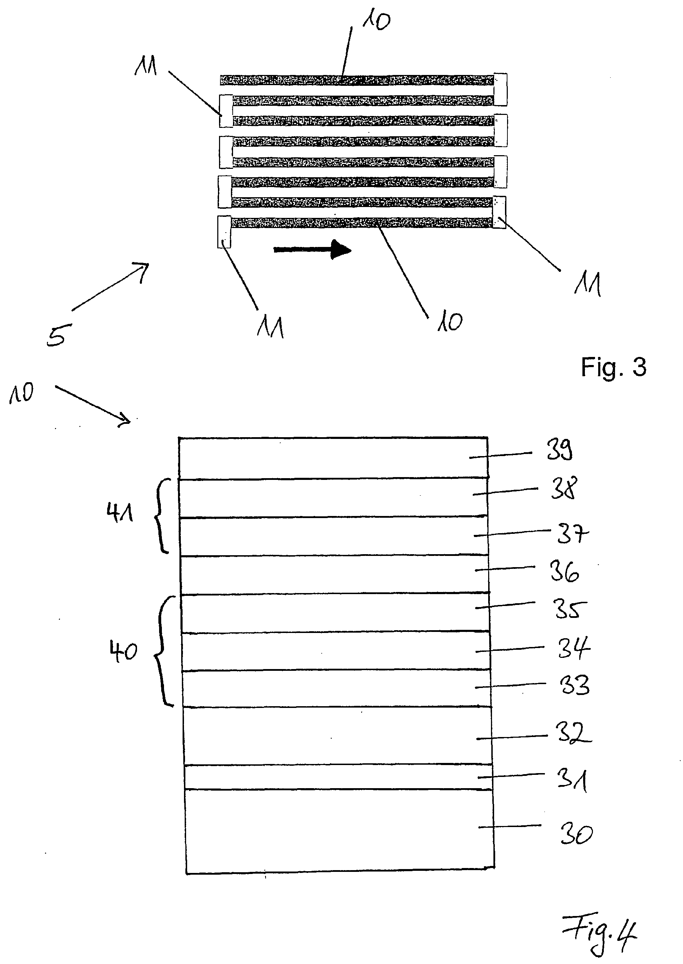

Die Erfindung wird anhand der Zeichnungen und in der nachfolgenden Beschreibung näher erläutert. Es zeigt Figur 1 mehrere Simulationskurven für den Winkelfehler eines auf der Grundlage des GMR-Effektes arbeitenden Schichtsystems nach dem Spin-Valve-Prinzip als Funktion der Streifenbreite und als Funktion des Winkels zwischen der Längsrichtung dieses Streifens und der Richtung der Magnetisierung der Referenzschicht bei einem ersten Magnetfeld, Figur 2 eine Simulation analog zu Figur 1 bei einem zweiten, gegenüber Figur 1 stärkeren Magnetfeld, Figur 3 eine Draufsicht auf ein mäanderförmig ausgebildetes Schichtsystem mit bereichsweise vorgesehenen Kurzschlussbalken und Figur 4 einen Schnitt durch ein magnetoresistives Schichtsystem gemäß Figur 3.

### Ausführungsbeispiele

Die Figur 4 zeigt ein magnetoresistives Schichtsystem 10, das in Draufsicht zumindest bereichsweise, insbesondere vollständig, streifenförmig strukturiert ist. Dazu ist auf einem üblichen Substrat 30 eine Wachstumsschicht bzw. eine Bufferschicht 31 vorgesehen, auf der sich eine antiferromagnetische Schicht 32 befindet. Auf dieser Schicht 32 befindet sich ein Schichtsystem in Form eines künstlichen Antiferromagneten 40 mit einer ersten festgehaltenen Schicht 35, d.h. einer "gepinnten" Schicht oder einer Referenzschicht, einer Zwischenschicht 34 und einer zweiten festgehaltenen Schicht 33. Auf dem künstlichen Antiferromagneten 40 befindet sich weiter eine metallische Schicht 36 und auf dieser eine Detektionsschicht 41, die aus einer ersten Teilschicht 37 und einer zweiten Teilschicht 38 aufgebaut ist. Auf der Detektionsschicht 41 befindet sich schließlich eine übliche Deckschicht 39, beispielsweise aus Tantal.

Die erste festgehaltene Schicht 35 besteht aus einem ersten ferromagnetischen Material, bevorzugt einer CoFe-Legierung wie Co₉₀Fe₁₀. Die zweite festgehaltene Schicht 33 besteht aus einem zweiten ferromagnetischen Material, bevorzugt ebenfalls einer CoFe-Legierung wie Co₉₀Fe₁₀. Die Zwischenschicht 34 besteht aus einem nichtmagnetischen Material, vorzugsweise Ruthenium. Die Dicke der ersten festgehaltenen Schicht 35 ist kleiner, nämlich um 0,2 nm bis 0,8 nm, vorzugsweise um 0,2 nm bis 0,4 nm, kleiner als die Dicke der zweiten festgehaltenen Schicht 33. Die antiferromagnetische Schicht 32 besteht bevorzugt aus einer PtMn-Legierung wie Pt₅₀Mn₅₀. Die metallische Schicht 36 ist bevorzugt eine Kupferschicht. Die erste, zu der metallischen Schicht 36 benachbarte Teilschicht 37 der Detektionsschicht 41 besteht bevorzugt aus einer CoFe-Legierung wie-Co₉₀Fe₁₀ und die zweite Teilschicht 38 bevorzugt aus einer NiFe-Legierung wie Fe₁₉Ni₈₁.

Besonders bevorzugt weist die antiferromagnetische Schicht 32 eine Dicke von 20 nm bis 40 nm, insbesondere 30 nm, die zweite festgehaltene Schicht 33 eine Dicke von 2 nm bis 4 nm, insbesondere 2,4 nm, die Zwischenschicht 34 eine Dicke von 0,6 nm bis 0,8 nm, insbesondere 0,7 nm, die erste festgehaltene Schicht 35 eine Dicke von 1 nm bis 3,5 nm, insbesondere 2 nm, die metallische Schicht 36 eine Dicke von 1 nm bis 4 nm, insbesondere 2 nm, die erste Teilschicht 37 eine Dicke von 0,5 nm bis 2 nm, insbesondere 1 nm, und die zweite Teilschicht 38 eine Dicke von 1,5 nm bis 5 nm, insbesondere 3 nm, auf.

Insgesamt wird durch den Schichtaufbau gemäß Figur 4 erreicht, dass die Referenzschicht 35 eine von einer Richtung eines darauf einwirkenden äußeren Magnetfelds zumindest näherungsweise unbeeinflusste Magnetisierungsrichtung aufweist, sofern das Magnetfeld aus einem vorgegebenen Arbeitsintervall ausgewählt ist. Weiter weist die Detektionsschicht 41 eine Richtung der Magnetisierung auf, die zumindest näherungsweise stets parallel zu der Richtung einer in der Ebene des Schichtsystems 10 liegenden Komponente der Feldstärke eines äußeren Magnetfeldes ist.

Die Figur 3 zeigt eine Draufsicht auf Figur 4, wobei erkennbar ist, dass das streifenförmige Schichtsystem 10 insbesondere in Form eines Mäanders mit bereichsweise parallel verlaufenden Streifenabschnitten ausgebildet ist. Weiter sind dabei die Magnetisierungsrichtungen der Referenzschichten 35 dieser einzelnen, parallel verlaufenden Streifenabschnitte ebenfalls zumindest näherungsweise parallel zueinander orientiert. Daneben weist das streifenförmige Schichtsystem 10 bereichsweise senkrecht zu den parallel verlaufenden Streifenabschnitten verlaufende Streifenteile auf, die mit einer Leitschicht 11 bedeckt sind. Diese Leitschicht 11 ist eine elektrisch besonders gut leitfähige Schicht, insbesondere eine Beschichtung aus Aluminium, die parallel zu den betreffenden Streifenteilen verläuft und diese somit elektrisch kurzschließt oder überbrückt. Alternativ kann auch vorgesehen sein, dass diese Streifenteile aus dem Material der Leitschicht 11 bestehen, so dass diese die nebeneinander verlaufenden Streifenabschnitte analog Figur 3 bereichsweise verbinden.

In Figur 3 ist durch den eingezeichneten Pfeil die einheitliche Richtung der Magnetisierung der Referenzschichten 35 in den einzelnen, parallel zueinander verlaufenden streifenförmigen Schichtsystemen 10 eingezeichnet. Der Aufbau gemäß Figur 3 bildet ein magnetoresistives Sensorelement 5, das gemäß der Lehre von WO 00/79298 A2 in Form von Wheatstone'schen Brückenschaltungen verschaltet und zu einem Winkelsensor verbaut werden kann.

Der Winkelfehler von magnetoresistiven Schichtsystemen auf der Grundlage des GMR-Effektes nach dem Spin-Valve-Prinzip, wobei dieser Winkelfehler definiert ist als Differenz des Winkels zwischen der in der Ebene des Schichtsystems liegenden Komponente des äußeren Magnetfeldes und der Magnetisierungsrichtung der Referenzschicht des Schichtsystems bei einem dvernachlässigbar schwachen äußeren Magnetfeld und des aus dem Messsignal ermittelten Messwinkels zwischen der in der Ebene des Schichtsystems liegenden Komponente des äußeren Magnetfeldes und der Magnetisierungsrichtung der Referenzschicht, wird von mikroskopischen Energietermen der einzelnen Schichten des Schichtsystems 10 dominiert.

Im Idealfall sollte der Winkelfehler 0° sein, d.h. die Richtung der Magnetisierung der Referenzschicht 35 sollte völlig unbeeinflusst sein von einem äußeren Magnetfeld, und die Richtung der Magnetisierung der Detektionsschicht 41 sollte diesem äußeren Magnetfeld stets vollständig folgen und parallel zu diesem ausgerichtet sein.

In der Praxis führt jedoch die Anisotropie der Detektionsschicht 41 sowie eine ferromagnetische oder antiferromagnetische Restkopplung zwischen der Detektionsschicht 41 und der Referenzschicht 35 dazu, dass die Detektionsschicht 41 dem äußeren Magnetfeld nicht völlig frei folgt.

Vor allem die Formanisotropie ist ein wesentlicher Parameter, um den Winkelfehler zu reduzieren, da sich durch die Wahl der Breite der einzelnen Streifen bei dem Schichtsystem 10 die Stärke dieser Anisotropie einstellen lässt, und durch den Winkel zwischen der Längsrichtung dieses Streifens und der Richtung der Magnetisierung der Referenzschicht die Richtungsabhängigkeit dieser Formanisotropie.

So können durch Veränderung der Streifenbreite und des Winkels zwischen der Längsrichtung des Streifens und der Richtung der Magnetisierung der Referenzschicht bei einem vorgegebenen Magnetfeld diese Energieterme optimal auf das jeweilige Schichtsystem 10 angepasst werden.

Formal lassen sich die genannten Energieterme in das Stoner-Wohlfahrth-Modell des Magnetismus integrieren, und bei vorgegebenem äußeren Magnetfeld, das aus einem üblichen Arbeitsintervall für magnetoresistive Sensorelemente von 0,8 kA/m (entsprechend 1 mT) bis 80 kA/m (entsprechend 100 mT), insbesondere aus einem Bereich von 8 kA/m bis 30 kA/m, ausgewählt worden ist, berechnen.

Für das Schichtsystem 10 gemäß Figur 4 in der Struktur gemäß Figur 3 wurden Berechnungen unter Einbeziehung der Formanisotropie bzw. des AMR-Fehlers durchgeführt, die in Figur 1 und Figur 2 für ein Schichtsystem gemäß Figur 4 bzw. Figur 3 dargestellt sind.

Im Einzelnen ist in Figur 1 auf der x-Achse die Breite des streifenförmigen Schichtsystems 10 in µm im Bereich von 0 µm bis 80 µm aufgetragen. Auf der y-Achse ist der errechnete maximale Winkelfehler über alle möglichen Winkel eines externen Magnetfeldes des Sensorelementes 5 in Grad zwischen 0°, d.h. dem Idealfall, und 5° aufgetragen. Weiter wurde ein externes Magnetfeld mit einer Feldstärke von 12 kA/m, entsprechend 15 mT, angesetzt.

Die Figur 1 zeigt zunächst eine erste Simulation 20, die ausgehend von dem Schichtsystem 10 gemäß Figur 3 bzw. Figur 4 erfolgte. Das externe Magnetfeld hat dabei die Stärke 12 kA/m und wird über dem Schichtsystem 10 hinsichtlich der in der Ebene des Schichtsystems 10 liegenden Komponente der Feldstärke dieses äußeren Magnetfeldes einmal vollständig um 360° rotiert.

Bevorzugt ist das äußere Magnetfeld derart orientiert, dass es möglichst vollständig in der Ebene des Schichtsystems 10 liegt, das wie vorstehend erläutert aufgebaut ist.

Bei der Simulation 20 ist weiter in Abwesenheit des äußeren Magnetfeldes die Richtung der Magnetisierung der Referenzschicht 35 senkrecht zu der Längsrichtung des streifenförmigen Schichtsystems 10 ausgerichtet, d.h. der entsprechende Winkel beträgt 90° oder 270°. Weiter wurden bei der Simulation 20 lediglich intrinsische Effekte berücksichtigt, die zu dem aufgetragenen Winkelfehler führen, wobei zusätzliche magnetoresistive Effekte, d.h. vor allem ein sogenannter AMR-Fehler, außer Acht gelassen wurde. Dieser AMR-Fehler tritt in ferromagnetischen Schichten auf und zeigt eine cos²-Abhängigkeit von der Richtung der Magnetisierung und der Stromrichtung oder Streifenrichtung. Er überlagert den GMR-Effekt und hat in der Regel eine Stärke von 5% bis 30% des GMR-Effektes.

Man erkennt in der ersten Simulation 20, dass bei einer Streifenbreite von ca. 7 µm bei dem vorgegebenen Magnetfeld, das in der Praxis durch den vorhandenen Gebermagneten fest vorgegeben ist, bei wie erläutert vorgegebener Einstellung des Winkels zwischen der Längsrichtung des streifenförmigen Schichtsystems 10 und der Richtung der Magnetisierung der Referenzschicht 35 ein minimaler Winkelfehler auftritt, der nahezu bei 0° liegt.

Die Figur 1 zeigt weiter eine zweite Simulation 21, bei der zusätzlich zu der Simulation 21 auch der genannte AMR-Fehler berücksichtigt worden ist. Der AMR-Fehler führt nicht zu einer relevanten Veränderung der zweiten Simulation 21 gegenüber der ersten Simulation 20.

Insofern ist es auch in diesem Fall bei dem vorgegebenen Magnetfeld und der vorgegebenen Orientierung der Richtung der Magnetisierung der Referenzschicht 35 senkrecht zu der Längsrichtung des streifenförmigen Schichtsystems hinsichtlich der Minimierung des maximalen Winkelfehlers am Besten, eine Streifenbreite von ca. 7 µm zu wählen.

In Figur 1 ist weiter eine dritte Simulation 22 aufgetragen, die der ersten Simulation 20 entspricht, wobei jedoch nun die Richtung der Magnetisierung der Referenzschicht 35 bei gegebenem Magnetfeld parallel zu der Längsrichtung des streifenförmigen Schichtsystems, d.h. unter einem Winkel von 0° oder 180°, eingestellt worden ist. Erneut wurde in der dritten Simulation 22 der AMR-Fehler zunächst vernachlässigt. Wird dieser berücksichtigt, ergibt sich die vierte Simulation 23 bei ansonsten gleichen Parametern.

Aus den Simulationen 22, 23 ist zu entnehmen, dass es kein Minimum für den maximalen Winkelfehler als Funktion der Streifenbreite gibt.

Aus Figur 1 ist insgesamt entnehmbar, dass es unabhängig von der Breite der Streifen des streifenförmigen Schichtsystems 10 stets günstiger ist, bei dem gegebenen Magnetfeld von 12 kA/m die Richtung der Magnetisierung der Referenzschicht 35 senkrecht zu der Längsrichtung des streifenförmigen Schichtsystems zu wählen, da unabhängig von der Streifenbreite der maximale Winkelfehler dann stets kleiner ist, als im Fall einer Wahl des Winkels von 0° bis 180°. Insbesondere ergibt sich, dass die Wahl eines Winkels von 90° bzw. 270° zwischen der Richtung der Magnetisierung der Referenzschicht 35 in Abwesenheit eines äußeren Magnetfeldes und der Längsrichtung des streifenförmigen Schichtsystems 10 stets zu einem niedrigeren maximalen Winkelfehler führt als andere Winkel.

Weiterhin ist Figur 1 entnehmbar, dass es neben der Abstimmung dieses Winkels auf das jeweilige äußere Magnetfeld definierter Feldstärke auch noch eine optimale Streifenbreite gibt, die den maximalen Winkelfehler weiter minimiert. Dieser Effekt ist sogar noch größer als der Effekt, der durch geschickte Wahl des Winkels zwischen der Richtung der Magnetisierung der Referenzschicht und der Längsrichtung des streifenförmigen Schichtsystems 10 erhalten wird.

Die Figur 2 zeigt eine zu Figur 1 weitgehend analoge Situation, wobei jedoch hier das externe Magnetfeld eine Feldstärke von 24 kA/m (entsprechend 30 mT) aufweist. Auch hier ist wiederum der maximale Winkelfehler in Grad als Funktion der Breite der Streifen des Schichtsystems 10 in µm entsprechend Figur 1 aufgetragen.

Unter dem maximalen Winkelfehler wird dabei erneut der bei Rotation des externen Magnetfeldes um 360° in der Ebene des Schichtsystems 10 maximal auftretende Winkelfehler entsprechend der genannten Definition verstanden.

In Figur 2 ist zunächst eine fünfte Simulation 24 an einem Schichtsystem 10 bzw. Sensorelement 5 gemäß Figur 3 oder 4 analog zu Figur 1 aufgetragen, die unter der Annahme eines externen Magnetfeldes von 24 kA/m und eines Winkels zwischen der Magnetisierungsrichtung der Referenzschicht in Abwesenheit des äußeren Magnetfeldes und der Längsrichtung des streifenförmigen Schichtsystems 10 von 90° bzw. 270° erfolgte. In der fünften Simulation 24 wurde der GMR-Fehler sowie der AMR-Fehler, der durch Formanisotropiebeiträge hervorgerufen wird, berücksichtigt. Eine der fünften Simulation ansonsten entsprechende sechste Simulation 25 vernachlässigt diesen AMR-Fehler.

Man erkennt bei einem Vergleich von Figur 2 und Figur 1, dass die Simulationen 24, 25 im Unterschied zu den Simulationen 20, 21 kein Minimum des maximalen Winkelfehlers zeigen, der zudem absolut betrachtet auch noch größer ist.

In Figur 2 ist weiter eine achte Simulation 27 aufgetragen, die sich von der fünften Simulation 24 lediglich dadurch unterscheidet, dass die Richtung der Magnetisierung der Referenzschicht 35 parallel zu der Längsrichtung des streifenförmigen Schichtsystems 10, d.h. unter einem Winkel von 0° oder 180°, gewählt worden ist. In der achten Simulation 27 ist neben dem GMR-Fehler auch der AMR-Fehler berücksichtigt worden, während eine siebte Simulation 26 diesen AMR-Fehler bei ansonsten gleichen Simulationsbedingungen im Vergleich zu der achten Simulation 27 vernachlässigt.

In diesem Fall beobachtet man, dass einerseits der maximale Winkelfehler bei dem vorgegebenen Magnetfeld bei einem Winkel zwischen der Magnetisierungsrichtung der Referenzschicht in Abwesenheit des äußeren Magnetfeldes und der Längsrichtung des streifenförmigen Schichtsystems 10 von 0° oder 180° zu einem deutlich reduzierten Winkelfehler gegenüber einem entsprechenden Winkel von 90° oder 270° führt. Insofern ist die Situation bei dem angenommenen Magnetfeld gemäß Figur 2 genau umgekehrt als im Fall der Figur 1. Daneben beobachtet man dann, dass der maximale Winkelfehler dadurch weiter reduziert werden kann, dass man eine optimale Streifenbreite auswählt, die im Beispiel gemäß Figur 2 bei ca. 10 µm liegt.

Die Strategie, die sich aus der Analyse der Simulationen gemäß Figur 1 oder 2 ergibt, lautet somit: Man gebe zunächst das äußere Magnetfeld aus einem Arbeitsintervall vor, dem das Sensorelement bei Betrieb ausgesetzt ist. Danach suche dann man den Winkel zwischen der Magnetisierungsrichtung der Referenzschicht 35 in Abwesenheit des äußeren Magnetfeldes und der Längsrichtung des streifenförmigen Schichtsystems 10, der zu einem minimalen maximalen Winkelfehler führt. Weiter optimiere man die Streifenbreite derart, dass man einen weiter reduzierten maximalen Winkelfehler erhält, d.h. man suche insbesondere die optimale Streifenbreite für einen minimalen maximalen Winkelfehler.

Aus den Simulationen gemäß Figur 1 bzw. 2 ist schließlich noch entnehmbar, dass der Winkel zwischen der Richtung der Magnetisierung der Referenzschicht in Abwesenheit des äußeren Magnetfeldes und der Längsrichtung des streifenförmigen Schichtsystems bevorzugt zu 0° bzw. 180° oder 90° bzw. 270° zu wählen ist. Die Einbeziehung des AMR-Fehlers führt zudem nicht zu wesentlichen Änderungen des Ergebnisses bei der Suche nach einem minimalen Winkelfehler.

Abschließend sei noch einmal betont, dass das Vorsehen der Leitschicht 11 in Form von Kurzschlussbalken gemäß Figur 3 zu einer besonders weitgehenden Reduktion des maximalen Winkelfehlers führt. Weiter sei betont, dass erfindungsgemäß bei dem künstlichen Antiferromagneten 40 die zweite festgehaltene Schicht 33 etwas dicker als die erste festgehaltene Schicht 35, d.h. die Referenzschicht, ist. Zudem ist der Schichtaufbau gemäß Figur 4 mit den genannten Materialien und Schichtdicken besonders günstig hinsichtlich der erläuterten Minimierung des Winkelfehlers.

## Patentansprüche

1. Magnetoresistives Sensorelement mit einem in Draufsicht zumindest bereichsweise streifenförmigen, auf der Grundlage des GMR-Effektes arbeitenden und nach dem Spin-Valve-Prinzip aufgebauten magnetoresistiven Schichtsystem (10), wobei das streifenförmige Schichtsystem (10) eine Referenzschicht (35) mit einer von einer Richtung eines darauf einwirkenden äußeren Magnetfeldes näherungsweise unbeeinflussten Magnetisierungsrichtung aufweist, und wobei das Sensorelement (5) bei Betrieb ein Messsignal bereitstellt, das sich als Funktion eines Messwinkels zwischen der in der Ebene des Schichtsystems (10) liegenden Komponente der Feldstärke des äußeren Magnetfeldes und der Magnetisierungsrichtung der Referenzschicht (35) verändert, und aus dem dieser Messwinkel ermittelbar ist, wobei, in Draufsicht auf das streifenförmige Schichtsystem (10) betrachtet, der Winkel zwischen der Magnetisierungsrichtung der Referenzschicht (35) in Abwesenheit des äußeren Magnetfeldes und der Längsrichtung des streifenförmigen Schichtsystems (10) derart eingestellt ist, dass bei einem Einwirken des äußeren Magnetfeldes mit einer definierten Feldstärke, die aus einem vorgegebenen Arbeitsintervall ausgewählt ist, der Winkelfehler des Schichtsystems (10) als Funktion dieses Winkels und der Feldstärke zumindest näherungsweise minimal ist, wobei der Winkelfehler definiert ist als maximale Differenz des Winkels zwischen der in der Ebene des Schichtsystems (10) liegenden Komponente der Feldstärke des äußeren Magnetfeldes und der Magnetisierungsrichtung der Referenzschicht (35) bei einem vernachlässigbar schwachen äußeren Magnetfeld und des aus dem Messsignal ermittelbaren Messwinkels zwischen der in der Ebene des Schichtsystems (10) liegenden Komponente der Feldstärke des äußeren Magnetfeldes über alle möglichen Richtungen des äußeren Magnetfeldes und der Magnetisierungsrichtung der Referenzschicht (35), wobei das streifenförmige Schichtsystem (10) einen künstlichen Antiferromagneten (40) mit einer ersten festgehaltenen Schicht (35) und einer zweiten festgehaltenen Schicht (33) aufweist, die über eine Zwischenschicht (34) voneinander getrennt sind, wobei die Referenzschicht (35) die erste festgehaltene Schicht (35) ist, die erste festgehaltene Schicht (35) aus einem ersten ferromagnetischen Material, insbesondere einer CoFe-Legierung, und die zweite festgehaltene Schicht (33) aus einem zweiten ferromagnetischen Material, insbesondere einer CoFe-Legierung, besteht, und dass die Zwischenschicht (34) aus einem nichtmagnetischen Material, insbesondere Ruthenium, besteht, **dadurch gekennzeichnet, dass** die Dicke der ersten festgehaltenen Schicht (35) kleiner, nämlich 0,2 nm bis 0,8 nm kleiner, als die Dicke der zweiten festgehaltenen Schicht (33) ist.

2. Magnetoresistives Sensorelement nach Anspruch 1, **dadurch gekennzeichnet, dass**, in Draufsicht auf das streifenförmige Schichtsystem (10) betrachtet, der Winkel zwischen der Magnetisierungsrichtung der Referenzschicht (35) in Abwesenheit des äußeren Magnetfeldes und der Längsrichtung des streifenförmigen Schichtsystems (10) sowie die Breite des streifenförmigen Schichtsystems (10) derart aufeinander abgestimmt eingestellt sind, dass ein bei einem Einwirken des äußeren Magnetfeldes mit einer definierten Feldstärke, die aus einem vorgegebenen Arbeitsintervall ausgewählt ist, der Winkelfehler des Schichtsystems (10) als Funktion dieses Winkels, der Feldstärke und der Breite des Schichtsystems (10) zumindest näherungsweise minimal ist.

3. Magnetoresistives Sensorelement nach Anspruch 1 oder 2, **dadurch gekennzeichnet, dass** die Feldstärke des äußeren Magnetfeldes aus dem Arbeitsintervall von 0,8 kA/m bis 80 kA/m, insbesondere 8 kA/m bis 30 kA/m, ausgewählt ist, und dass der Winkel zwischen der Magnetisierungsrichtung der Referenzschicht (35) in Abwesenheit des äußeren Magnetfeldes und der Längsrichtung des streifenförmigen Schichtsystems (10) zumindest näherungsweise 0° oder 90° oder 180° oder 270° beträgt.

4. Magnetoresistives Sensorelement nach einem der vorangehenden Ansprüche, **dadurch gekennzeichnet, dass** die Breite des streifenförmigen Schichtsystems (10) aus dem Intervall von 1 µm bis 100 µm, insbesondere 2 µm bis 30 µm, ausgewählt ist.

5. Magnetoresistives Sensorelement nach einem der vorangehenden Ansprüche, **dadurch gekennzeichnet, dass** die zweite festgehaltene Schicht (33) zu einer antiferromagnetischen Schicht (32), insbesondere einer Schicht aus einer PtMn-Legierung, benachbart ist.

6. Magnetoresistives Sensorelement nach einem der vorangehenden Ansprüche, **dadurch gekennzeichnet, dass** die erste festgehaltene Schicht (35) zu einer metallischen Schicht (36), insbesondere aus Kupfer, benachbart ist, und dass die metallische Schicht (36) zu einer Detektionsschicht (41) benachbart ist, die eine Magnetisierung ausweist, deren Richtung stets zumindest näherungsweise parallel zu der Richtung der in der Ebene des Schichtsystems (10) liegenden Komponente der Feldstärke des äußeren Magnetfeldes ist.

7. Magnetoresistives Sensorelement nach Anspruch 6, **dadurch gekennzeichnet, dass** die Detektionsschicht (41) aus mindestens zwei Teilschichten (37, 38) aufgebaut ist, wobei eine erste, zu der metallischen Schicht (36) benachbarte Teilschicht (37) aus einerCoFe-Legierung besteht, und wobei eine zweite Teilschicht (38) aus einer NiFe-Legierung besteht.

8. Magnetoresistives Sensorelement nach einem der vorangehenden Ansprüche, **dadurch gekennzeichnet, dass** die antiferromagnetische Schicht (32) eine Dicke von 20 nm bis 40 nm, insbesondere 30 nm, die zweite festgehaltene Schicht (33) eine Dicke von 2 nm bis 4 nm, insbesondere 2,4 nm, die Zwischenschicht (34) eine Dicke von 0,6 nm bis 0,8 nm, insbesondere 0,7 nm, die erste festgehaltene Schicht (35) eine Dicke von 1 nm bis 3,5 nm, insbesondere 2 nm, die metallische Schicht (36) eine Dicke von 1 nm bis 4 nm, insbesondere 2 nm, die erste Teilschicht (37) eine Dicke von 0,5 nm bis 2 nm, insbesondere 1 nm, und die zweite Teilschicht (38) eine Dicke von 1,5 nm bis 5 nm, insbesondere 3 nm, aufweist.

9. Magnetoresistives Sensorelement nach einem der vorangehenden Ansprüche, **dadurch gekennzeichnet, dass** das streifenförmige Schichtsystem (10) in Draufsicht in Form eines Mäanders mit bereichsweise parallel verlaufenden Streifenabschnitten ausgebildet ist, wobei die Magnetisierungsrichtungen der Referenzschichten (35) der Streifenabschnitte zumindest näherungsweise parallel zueinander orientiert sind.

10. Magnetoresistives Sensorelement nach Anspruch 9, **dadurch gekennzeichnet, dass** das streifenförmige Schichtsystem (10) bereichsweise nicht parallel sondern insbesondere senkrecht zu den Streifenabschnitten verlaufende Streifenteile aufweist, und dass eine elektrisch gut leitfähige Leitschicht (11), insbesondere eine Beschichtung aus Aluminium, vorgesehen ist, die parallel insbesondere auf oder unter diesen Streifenteilen verläuft und diese zumindest näherungsweise elektrisch kurzschließt oder überbrückt, oder dass die Streifenteile aus einem elektrisch gut leitfähigen Material, insbesondere Aluminium, ausgebildet sind.

11. Verfahren zur Reduktion des Winkelfehlers eines magnetoresistiven Sensorelementes, insbesondere nach einem der vorangehenden Ansprüche, mit einem in Draufsicht zumindest bereichsweise streifenförmigen, auf der Grundlage des GMR-Effektes arbeitenden und nach dem Spin-Valve-Prinzip aufgebauten magnetoresistiven Schichtsystem (10), wobei das streifenförmige Schichtsystem (10) eine Referenzschicht (35) mit einer von einer Richtung eines darauf einwirkenden äußeren Magnetfeldes näherungsweise unbeeinflussten Magnetisierungsrichtung aufweist, und wobei das Sensorelement (5) bei Betrieb ein Messsignal bereitstellt, das sich als Funktion eines Messwinkels zwischen der in der Ebene des Schichtsystems (10) liegenden Komponente der Feldstärke des äußeren Magnetfeldes und der Magnetisierungsrichtung der Referenzschicht (35) verändert, und aus dem dieser Messwinkelermittelt wird, wobei, in Draufsicht auf das streifenförmige Schichtsystem (10) betrachtet, der Winkel zwischen der Magnetisierungsrichtung der Referenzschicht (35) in Abwesenheit des äußeren Magnetfeldes und der Längsrichtung des streifenförmigen Schichtsystems (10) derart eingestellt wird, dass ein bei einem Einwirken des äußeren Magnetfeldes mit einer definierten Feldstärke, die aus einem vorgegebenen Arbeitsintervall ausgewählt wird, der Winkelfehler des Schichtsystems (10) als Funktion dieses Winkels und der Feldstärke zumindest näherungsweise minimal ist, wobei der Winkelfehler definiert ist als maximale Differenz des Winkels zwischen der in der Ebene des Schichtsystems (10) liegenden Komponente der Feldstärke des äußeren Magnetfeldes und der Magnetisierungsrichtung der Referenzschicht (35) bei einem vernachlässigbar schwachen äußeren Magnetfeld und des aus dem Messsignal ermittelbaren Messwinkels zwischen der in der Ebene des Schichtsystems (10) liegenden Komponente der Feldstärke des äußeren Magnetfeldes über alle möglichen Richtungen des äußeren Magnetfeldes und der Magnetisierungsrichtung der Referenzschicht (35), wobei das streifenförmige Schichtsystem (10) einen künstlichen Antiferromagneten (40) mit einer ersten festgehaltenen Schicht (35) und einer zweiten festgehaltenen Schicht (33) aufweist, die über eine Zwischenschicht (34) voneinander getrennt sind, wobei die Referenzschicht (35) die erste festgehaltene Schicht (35) ist, die erste festgehaltene Schicht (35) aus einem ersten ferromagnetischen Material, insbesondere einer CoFe-Legierung, und die zweite festgehaltene Schicht (33) aus einem zweiten ferromagnetischen Material, insbesondere einer CoFe-Legierung, besteht, und dass die Zwischenschicht (34) aus einem nichtmagnetischen Material, insbesondere Ruthenium, besteht, **dadurch gekennzeichnet, dass** die Dicke der ersten festgehaltenen Schicht (35) kleiner, nämlich 0,2 nm bis 0,8 nm kleiner, als die Dicke der zweiten festgehaltenen Schicht (33) gewählt wird.

12. Verfahren nach Anspruch 11, **dadurch gekennzeichnet, dass**, in Draufsicht auf das streifenförmige Schichtsystem (10) betrachtet, der Winkel zwischen der Magnetisierungsrichtung der Referenzschicht (35) in Abwesenheit des äußeren Magnetfeldes und der Längsrichtung des streifenförmigen Schichtsystems (10) sowie die Breite des streifenförmigen Schichtsystems (10) derart aufeinander abgestimmt eingestellt werden, dass ein bei einem Einwirken des äußeren Magnetfeldes mit einer definierten Feldstärke, die aus einem vorgegebenen Arbeitsintervall ausgewählt ist, der Winkelfehler des Schichtsystems (10) als Funktion dieses Winkels, der Feldstärke und der Breite des Schichtsystems (10) zumindest näherungsweise minimal ist.

## Claims

1. Magnetoresistive sensor element having a magnetoresistive layer system (10) which is in the form of strips at least in places in a plan view, operates on the basis of the GMR effect and is designed using the spin-valve principle, with the layer system (10), which is in the form of strips, having a reference layer (35) with a magnetization direction which is approximately uninfluenced by the direction of an external magnetic field acting on it, and with the sensor element (5) producing a measurement signal during operation, which changes as a function of the angle measured between that component of the field strength of the external magnetic field which is on the same plane as the layer system (10) and the magnetization direction of the reference layer (35), and from which this measured angle can be determined, in which case, when considered in a plan view of the layer system (10) which is in the form of strips, the angle between the magnetization direction of the reference layer (35) in the absence of the external magnetic field and the longitudinal direction of the layer system (10) which is in the form of strips is set such that, under the influence of the external magnetic field with the defined field strength which is selected from a predetermined working interval, the angle error of the layer system (10) is at least approximately a minimum as a function of this angle and of the field strength, with the angle error being defined as the maximum angle difference between that component of the field strength of the external magnetic field which is on the same plane as the layer system (10) and the magnetization direction of the reference layer (35) when the external magnetic field is negligibly weak, and the measured angle, which can be determined from the measurement signal, between that component of the field strength of the external magnetic field which is on the same plane as the layer system (10), over all possible directions of the external magnetic field, and the magnetization direction of the reference layer (35), with the layer system (10), which is in the form of strips, having a synthetic antiferromagnet (40) with a first firmly held layer (35) and a second firmly held layer (33), which are separated from one another by an intermediate layer (34), with the reference layer (35) being the first firmly held layer (35), the first firmly held layer (35) being composed of a first ferromagnetic material, in particular of a CoFe alloy, and with the second firmly held layer (33) being composed of a second ferromagnetic material, in particular of a CoFe alloy, and in that the intermediate layer (34) is composed of a non-magnetic material, in particular ruthenium, **characterized in that** the thickness of the first firmly held layer (35) is less, specifically 0.2 nm to 0.8 nm less, than the thickness of the second firmly held layer (33).

2. Magnetoresistive sensor element according to Claim 1, **characterized in that**, considered in a plan view of the layer system (10) which is in the form of strips, the angle between the magnetization direction of the reference layer (35) in the absence of the external magnetic field and the longitudinal direction of the layer system (10), which is in the form of strips, as well as the width of the layer system (10), which is in the form of strips, are set such that they match one another such that, under the influence of the external magnetic field with a defined field strength which is selected from a predetermined operating interval, the angle error of the layer system (10) is at least approximately a minimum as a function of this angle, the field strength and the width of the layer system (10).

3. Magnetoresistive sensor element according to Claim 1 or 2, **characterized in that** the field strength of the external magnetic field is selected from the operating interval from 0.8 kA/m to 80 kA/m, in particular 8 kA/m to 30 kA/m, and **in that** the angle between the magnetization direction of the reference layer (35) in the absence of the external magnetic field and the longitudinal direction of the layer system (10), which is in the form of strips, is at least approximately 0°, 90°, 180° or 270°.

4. Magnetoresistive sensor element according to one of the preceding claims, **characterized in that** the width of the layer system (10) which is in the form of strips is selected from the interval between 1 µm and 100 µm, in particular between 2 µm and 30 µm.

5. Magnetoresistive sensor element according to one of the preceding claims, **characterized in that** the second firmly held layer (33) is adjacent to an antiferromagnetic layer (32), in particular a layer composed of a PtMn alloy.

6. Magnetoresistive sensor element according to one of the preceding claims, **characterized in that** the first firmly held layer (35) is adjacent to a metallic layer (36), in particular composed of copper, and **in that** the metallic layer (36) is adjacent to a detection layer (41) whose magnetization direction is always at least approximately parallel to the direction of that component of the field strength of the external magnetic field which is on the same plane as the layer system (10).

7. Magnetoresistive sensor element according to Claim 6, **characterized in that** the detection layer (41) is formed from at least two layer elements (37, 38), with a first layer element (37), which is adjacent to the metallic layer (36), being composed of a CoFe alloy, and with a second layer element (38) being composed of an NiFe alloy.

8. Magnetoresistive sensor element according to one of the preceding claims, **characterized in that** the antiferromagnetic layer (32) has a thickness of 20 nm to 40 nm, in particular 30 nm, the second firmly held layer (33) has a thickness of 2 nm to 4 nm, in particular 2.4 nm, the intermediate layer (34) has a thickness of 0.6 nm to 0.8 nm, in particular 0.7 nm, the first firmly held layer (35) has a thickness of 1 nm to 3.5 nm, in particular 2 nm, the metallic layer (36) has a thickness of 1 nm to 4 nm, in particular 2 nm, the first layer element (37) has a thickness of 0.5 nm to 2 nm, in particular 1 nm, and the second layer element (38) has a thickness of 1.5 nm to 5 nm, in particular 3 nm.

9. Magnetoresistive sensor element according to one of the preceding claims, **characterized in that** the layer element (10), which is in the form of strips, is, when considered in the form of a plan view, in the form of a meander with strip sections which run parallel in places, with the magnetization directions of the reference layers (35) of the strip sections being oriented at least approximately parallel to one another.

10. Magnetoresistive sensor element according to Claim 9, **characterized in that** the layer system (10), which is in the form of strips, has strip parts which run in particular at right angles to the strip sections rather than parallel, in places, and **in that** an electrically highly conductive layer (11), in particular a coating composed of aluminium, is provided, runs parallel, in particular on or under these strip parts, and at least approximately electrically shorts or bridges them, or **in that** the strip parts are formed from an electrically highly conductive material, in particular aluminium.

11. Method for reduction of the angle error of a magnetoresistive sensor element, in particular according to one of the preceding claims, having a magnetoresistive layer system (10) which is in the form of strips at least in places in a plan view, operates on the basis of the GMR effect and is designed using the spin-valve principle, with the layer system (10), which is in the form of strips, having a reference layer (35) with a magnetization direction which is approximately uninfluenced by the direction of an external magnetic field acting on it, and with the sensor element (5) producing a measurement signal during operation, which changes as a function of the angle measured between that component of the field strength of the external magnetic field which is on the same plane as the layer system (10) and the magnetization direction of the reference layer (35), and from which this measured angle is determined, in which case, when considered in a plan view of the layer system (10) which is in the form of strips, the angle between the magnetization direction of the reference layer (35) in the absence of the external magnetic field and the longitudinal direction of the layer system (10) which is in the form of strips is set such that, under the influence of the external magnetic field with a defined field strength which is selected from a predetermined working interval, the angle error of the layer system (10) is at least approximately a minimum as a function of this angle and of the field strength, with the angle error being defined as the maximum angle difference between that component of the field strength of the external magnetic field which is on the same plane as the layer system (10) and the magnetization direction of the reference layer (35) when the external magnetic field is negligibly weak, and the measured angle, which can be determined from the measurement signal, between that component of the field strength of the external magnetic field which is on the same plane as the layer system (10), over all possible directions of the external magnetic field, and the magnetization direction of the reference layer (35), with the layer system (10), which is in the form of strips, having a synthetic antiferromagnet (40) with a first firmly held layer (35) and a second firmly held layer (33), which are separated from one another by an intermediate layer (34), with the reference layer (35) being the first firmly held layer (35), the first firmly held layer (35) being composed of a first ferromagnetic material, in particular of a CoFe alloy, and with the second firmly held layer (33) being composed of a second ferromagnetic material, in particular of a CoFe alloy, and in that the intermediate layer (34) is composed of a non-magnetic material, in particular ruthenium, **characterized in that** the thickness of the first firmly held layer (35) is less, specifically 0.2 nm to 0.8 nm less, than the thickness of the second firmly held layer (33).

12. Method according to Claim 11, **characterized in that**, considered in a plan view of the layer system (10) which is in the form of strips, the angle between the magnetization direction of the reference layer (35) in the absence of the external magnetic field and the longitudinal direction of the layer system (10), which is in the form of strips, as well as the width of the layer system (10), which is in the form of strips, are set such that they match one another such that, under the influence of the external magnetic field with a defined field strength which is selected from a predetermined operating interval, the angle error of the layer system (10) is at least approximately a minimum as a function of this angle, the field strength and the width of the layer system (10).

## Revendications

1. Elément de détection magnéto-résistif comportant en vue de dessus, au moins par zones, un système (10) de couches en forme de bandes, fonctionnant suivant le principe de l'effet GMR et construit suivant le principe de la soupape Spin,
le système de couches (10) en forme de bandes ayant une couche de référence (35) avec une direction d'aimantation pratiquement non influencée par la direction d'un champ magnétique extérieur agissant sur celui-ci, et
en fonctionnement, l'élément de détection (5) fournit un signal de mesure qui varie en fonction de la mesure de l'angle entre la composante de l'intensité du champ, située dans le plan du système de couches (10) du champ magnétique extérieur et la direction d'aimantation de la couche de référence (35) et à partir de ce signal, on détermine la mesure de l'angle,
considéré en vue de dessus sur le système de couches (10) en forme de bandes, l'angle entre la direction d'aimantation de la couche de référence (35) en l'absence de champ magnétique extérieur et la direction longitudinale du système de couches (10) en forme de bandes est réglé pour que sous l'action du champ magnétique extérieur d'une intensité de champ définie, choisie dans un intervalle de travail prédéfini, l'erreur angulaire du système de couches (10), en fonction de cet angle et de l'intensité du champ, est au moins sensiblement minimum,
l'erreur angulaire étant définie comme différence maximale de l'angle entre la composante de l'intensité du champ magnétique extérieur situé dans le plan du système de couches (10) et la direction d'aimantation de la couche de référence (35) pour un champ magnétique extérieur faible, négligeable, et de l'angle de mesure déterminé à partir du signal de mesure entre la composante de l'intensité du champ magnétique extérieur situé dans le plan du système de couches (10) pour toutes les directions possibles du champ magnétique extérieur et la direction d'aimantation de la couche de référence (35),
le système de couches (10) en forme de bandes ayant un aimant synthétique antiferromagnétique (40) avec une première couche (35) bloquée et une seconde couche (33), bloquée, séparées l'une de l'autre par une couche intermédiaire (34),
la couche de référence (35) étant la première couche bloquée (35),
la première couche bloquée (35) étant en une première matière ferromagnétique, notamment en un alliage CoFe et la seconde couche bloquée (33) étant en une seconde matière ferromagnétique, notamment en un alliage CoFe et la couche intermédiaire (34) est en une matière non magnétique, notamment en ruthénium,
**caractérisé en ce que**
l'épaisseur de la première couche bloquée (35) est inférieure, notamment inférieure de 0,2 nm jusqu'à 0,8 nm, à l'épaisseur de la seconde couche bloquée (33).

2. Elément de détection magnéto-résistif selon la revendication 1,
**caractérisé en ce qu'**
en vue de dessus sur le système de couches (10), en forme de bandes, l'angle entre la direction d'aimantation de la couche de référence (35) en l'absence de champ magnétique extérieur et la direction longitudinale du système de couches (10) en forme de bandes ainsi que la largeur du système de couches (10) en forme de bande sont définis les uns par rapport aux autres pour que, sous l'action du champ magnétique extérieur d'une intensité de champ définie, choisie dans un intervalle de travail prédéfini, soit au moins sensiblement minimum l'erreur angulaire du système de couches (10) en fonction de cet angle, de l'intensité du champ et de la largeur du système de couche (10).

3. Elément de détection magnéto-résistif selon la revendication 1 ou 2,
**caractérisé en ce que**
l'intensité du champ magnétique extérieur est choisie dans l'intervalle de travail entre 0,8 kA/m jusqu'à 80 kA/m, notamment 8 kA/m jusqu'à 30 kA/m et
l'angle entre la direction d'aimantation de la couche de référence (35) en l'absence de champ magnétique extérieur et la direction longitudinale du système de couches (10) en forme de bandes est au moins sensiblement égal à 0° ou 90° ou 180° ou 270°.

4. Elément de détection magnéto-résistif selon l'une des revendications précédentes,
**caractérisé en ce que**
la largeur du système de couches (10) en forme de bandes est choisie dans un intervalle compris entre 1 µm jusqu'à 100 µm et notamment 2 µm jusqu'à 30 µm.

5. Elément de détection magnéto-résistif selon l'une des revendications précédentes,
**caractérisé en ce que**
la seconde couche fixée (33) est voisine d'une couche antiferromagnétique (32), notamment une couche en un alliage PtMn.

6. Elément de détection magnéto-résistif selon l'une des revendications précédentes,
**caractérisé en ce que**
la première couche fixée (35) est voisine d'une couche métallique (36), notamment en cuivre, et
la couche métallique (36) est voisine d'une couche de détection (41) ayant une aimantation dont la direction est toujours au moins sensiblement parallèle à la direction de la composante de l'intensité du champs magnétique extérieur situé dans le plan du système de couches (10).

7. Elément de détection magnéto-résistif selon la revendication 6,
**caractérisé en ce que**
la couche de détection (41) est construite d'au moins deux couches partielles (37, 38),
la première couche partielle (37) voisine de la couche métallique (36) étant en alliage CoFe et une seconde couche partielle (38) étant en un alliage NiFe.

8. Elément de détection magnéto-résistif selon l'une des revendications précédentes,
**caractérisé en ce que**
la couche antiferromagnétique (32) a une épaisseur de 20 nm jusqu'à 40 nm, notamment 30 nm, la seconde fixée (33) ayant une épaisseur comprise entre 2 nm et 4 nm, notamment 2,4 nm, la couche intermédiaire (34) a une épaisseur de 0,6 nm jusqu'à 0,8 nm, notamment 0,7 nm, la première couche fixée (35) a une épaisseur comprise entre 1 nm et 3,5 nm, notamment égale à 2 nm, la couche métallisée (36) a une épaisseur de 1 nm jusqu'à 4 nm, notamment 2 nm, la première couche partielle (37) a une épaisseur de 0,5 nm jusqu'à 2 nm, notamment 1 nm et la seconde couche partielle (38) a une épaisseur de 1,5 nm jusqu'à 5 nm, notamment 3 nm.

9. Elément de détection magnéto-résistif selon l'une des revendications précédentes,
**caractérisé en ce que**
le système de couches (10) en forme de bandes, en vue de dessus, a une forme de méandres avec par zones, des segments de bande parallèles et les directions d'aimantation des couches de référence (35) des segments de bande sont orientées au moins sensiblement parallèlement.

10. Elément de détection magnéto-résistif selon la revendication 9,
**caractérisé en ce que**
le système de couches (10) en forme de bandes comporte par zones, des parties de bandes qui ne sont pas parallèles mais notamment perpendiculaires aux segments de bandes et
une couche conductrice (11) bonne conductrice électrique, notamment un revêtement d'aluminium, est prévue parallèle au-dessus ou en dessous des parties de bandes et qui les court-circuite ou chevauche au moins sensiblement, électriquement ou les parties de bande sont en une matière bonne conductrice d'électricité notamment en aluminium.

11. Procédé de réduction de l'erreur angulaire d'un élément de détection magnétorésistif, notamment selon l'une des revendications précédentes, comportant un système de couche magnétorésistif (10), fonctionnant selon le principe de l'effet GMR et construit suivant le principe de la soupape Spin,
le système de couches (10) en forme de bandes ayant une couche de référence (35) avec une direction d'aimantation pratiquement non influencée par une direction d'un champ magnétique extérieur, agissant, et
l'élément de détecteur (5) fournissant en fonctionnement un signal de mesure qui varie en fonction d'une mesure de l'angle entre la composante de l'intensité du champ magnétique extérieur dans le plan du système de couche (10) et la direction d'aimantation de la couche de référence (35) et à partir de laquelle on détermine cette mesure d'angle, en vue de dessus du système de couches (10) en forme de bandes, l'angle entre la direction d'aimantation de la couche de référence (35) en l'absence du champ magnétique extérieur et la direction longitudinale du système de couches (10) en forme de bandes est réglé pour que sous l'action du champ magnétique extérieur avec une intensité de champ définie sélectionnée dans un intervalle de travail prédéfini, l'erreur angulaire du système de couches (10) soit au moins pratiquement minimum comme fonction de cet angle et de l'intensité du champ, l'erreur angulaire étant définie comme différence maximale de l'angle entre la composante de l'intensité du champ magnétique extérieur dans le plan du système de couches (10) et la direction d'aimantation de la couche de référence (35) pour un champ magnétique extérieur faible, négligeable et la mesure de l'angle qui se détermine à partir du signal de mesure entre la composante de l'intensité du champ magnétique extérieur situé dans le plan du système de couches (10) pour toutes les directions possibles du champ magnétique extérieur et la direction d'aimantation de la couche de référence (35), le système de couches (10) en forme de bandes ayant un aimant artificiel antiferromagnétique (40) avec une première couche fixée (35) et une seconde couche fixée (33), ces couches étant séparées l'une de l'autre par une couche intermédiaire (34),
la couche de référence (35) étant la première couche fixée (35), la première couche fixée (35) étant en une première matière ferromagnétique, notamment en un alliage CoFe et la seconde couche fixée (33) étant en une seconde matière ferromagnétique, notamment un alliage CoFe et
la couche intermédiaire (34) est en une matière non magnétique, notamment en ruthénium,
**caractérisé en ce que**
l'épaisseur de la première couche fixée (35) est inférieure, notamment de 0,2 nm jusqu'à 0,8 nm à l'épaisseur de la seconde couche fixée (33).

12. Procédé selon la revendication 11,
**caractérisé en ce qu'**
en vue de dessus sur le système de couches (10) en forme de bandes, l'angle entre la direction d'aimantation de la couche de référence (35) en l'absence du champ magnétique extérieur et la direction longitudinale du système de couches (10) en forme de bandes ainsi que la largeur du système de couches (10) en forme de bandes sont réglés et accordés de façon relative pour que sous l'action du champ magnétique extérieur d'une intensité de champ définie, choisie dans un intervalle de travail prédéfini, l'erreur angulaire du système de couches (10) en fonction de cet angle, de l'intensité du champ et de la largeur du système de couches (10), soit au moins sensiblement minimum.
